# EUROPÄISCHE PATENTSCHRIFT

(11) **EP 0 412 184 B1**
(45) Veröffentlichungstag und Bekanntmachung des Hinweises auf die Patenterteilung: **21.06.1995**
(21) Anmeldenummer: 89114735.7
(22) Anmeldetag: 09.08.1989
(51) Int. Cl.: G02B 6/42, H01S 3/025, H01L 33/00, H01L 31/0203

(54) **Optoelektronischer Wandler mit einer Linsenkoppeloptik**
Optoelectronic converter with lens-coupling optics
Convertisseur opto-électronique muni d'optique de couplage à lentille

(43) Veröffentlichungstag der Anmeldung: 13.02.1991
(73) Patentinhaber: SIEMENS AKTIENGESELLSCHAFT, 80333 München (DE)
(72) Erfinder: Althaus, Hans Ludwig, Dr. rer. nat., D-8417 Lappersdorf (DE); Dietrich, Ralf, Dipl.-Ing., D-8000 München 90 (DE); Hufgard, Erich, Dipl.-Ing., D-8400 Regensburg (DE); Späth, Werner, Dipl.-Ing., D-8150 Holzkirchen (DE)

(56) Entgegenhaltungen:
- EP-A- 0 204 224
- EP-A- 0 259 018
- PATENT ABSTRACTS OF JAPAN, Band 13, Nr. 149 (P-855)[3497], 12. April 1989;& JP-A-63 311 314
- PATENT ABSTRACTS OF JAPAN, Band 6, Nr. 164 (E-127)[1042], 27. August 1982;& JP-A-57 83 081
- PATENT ABSTRACTS OF JAPAN, Band 8, Nr. 105 (P-274)[1542], 17. Mai 1984;& JP-A-59 15 211
- PATENT ABSTRACTS OF JAPAN, Band 8, Nr. 217 (E-270)[1654], 4. Oktober 1984;& JP-A-59 101 881

## Beschreibung

Die Erfindung betrifft einen optoelektronischen Wandler mit einer Linsenkoppeloptik nach dem Oberbegriff des Anspruchs 1.

Ein derartiges Lichtsende- oder empfangsbauelement und insbesondere ein Verfahren zu dessen Herstellung sowie eine Vorrichtung zum Durchführen des Verfahrens gehen aus der EP-A-0204224 als bekannt hervor. Bei diesem Bauelement, das insbesondere zum Koppeln an Lichtwellenleiter dient, kann als Koppeloptik auch eine Linse über einen Körper aus Halbleitermaterial indirekt auf einem Träger fixiert sein. Das Justieren und Fixieren der Linse erfolgt dabei über ein Befestigungsmaterial, vorzugsweise Lot, das zur Justage und Fixierung des als Linsenträger dienenden Festkörpers durch Aufheizen des Festkörpers flüssig aufgeschmolzen und anschließend abgekühlt wird.

Aus EP-A- 259 018 ist ebenfalls ein optoelektronischer Wandle mit Linsenkoppeloptik bekannt.

Bei solchen optoelektronischen Wandlern, die beispielsweise in Lichtwellenleiter-Sende- bzw. Empfängersystemen Anwendung finden, und bei denen als Koppeloptik Linsen, beispielsweise Kugellinsen, zur Ein- bzw. Auskopplung des vom Wandler herrührenden bzw. zu empfangenden Lichtes in bzw. aus einem Lichtwellenleiter, z.B. in Gestalt einer Glasfaser, verwendet werden, ist vor allem die Justage und Fixierung der Linse problematisch. Dies insbesondere im Hinblick darauf, daß die Halterung der Linse in exakt definierter Position unmittelbar vor dem Wandler erfolgen soll, und zwar über einen langen Zeitraum bei Toleranzen im Submikrometerbereich, wenn die optische Kopplung beispielsweise mit einem Lichtwellenleiter, z.B. einer Monomode-Glasfaser, vorgenommen werden soll. Außerdem soll ein möglichst einfaches und damit wenig zeitaufwendiges Justieren der Linse auf optimale Ein- bzw. Auskopplung ermöglicht werden. Weiterhin soll eine Beeinträchtigung des Wandlers bzw. aktiven Halbleiterchips durch die Linsenhalterung, z.B. durch mechanische Verspannung, vermieden werden. Schließlich ist man bestrebt, die äußeren Abmessungen des Wandlers trotz Linsenkoppeloptik möglichst klein zu halten.

Der Erfindung liegt die Aufgabe zugrunde, einen optoelektronischen Wandler mit einer Linsenkoppeloptik der eingangs genannten Art derart auszubilden, daß sich eine im Strahlengang unmittelbar vor dem Wandler angeordnete Linse auf möglichst einfach realisierbare Weise exakt justieren und anschließend fixieren läßt, so daß sich der Wandler aufgrund der präzisen und raumsparenden Linsenanordnung insbesondere sowohl als Lichtwellenleiter-Sende- oder -Empfangsbauelement als auch als Einzellichtquelle mit definierter Abstrahlcharakteristik besonders eignet.

Diese Aufgabe wird erfindungsgemäß durch einen optoelektronischen Wandler mit einer Linsenkoppeloptik mit den Merkmalen des Anspruchs 1 gelöst.

Vorteilhafte Ausgestaltungen bzw. Weiterbildungen der Erfindung sind Gegenstand zusätzlicher Ansprüche.

Die mit der Erfindung erzielten Vorteile bestehen insbesondere darin, daß durch die spezielle Anordnung von Wandlerbauelement und Linsenträger auf einem gemeinsamen Träger ein wesentlich kompakterer Aufbau des Bauelementes ermöglicht wird. Der kompakte Aufbau hat wiederum eine Verringerung des Raumbedarfs von Wandler mit Koppeloptik und damit eine Verkleinerung des Bauelements zur Folge. Von besonderem Vorteil ist jedoch die mit der speziellen Anordnung geschaffene Möglichkeit, eine Linse unmittelbar vor dem Wandlerbauelement auf einfache und rasche Weise justieren und anschließend fixieren zu können, und zwar mit einer solchen Präzision, daß die geringen Justagetoleranzen des Wandlers dessen Einsatz in Lichtwellenleiter-Sende- oder Empfangsvorrichtungen, insbesondere in Modulbauweise ohne zusätzlichen Justieraufwand der Linse erlauben.

Durch die erfindungsgemäße Maßnahme, daß der Wandler derart angeordnet ist, daß die Strahlachse des Wandlers senkrecht auf der von der Befestigungsschicht gebildeten Fläche steht, wird erreicht, daß eine Justage in Richtung der Strahlachse durch Variation der Dicke der Befestigungsschicht vorgenommen werden kann, und daß die vorzunehmende Feinjustage, die von wesentlich größerem Einfluß auf die Koppeloptik ist, in der empfindlicheren Ebene, d.h. der von der Befestigungsschicht gebildeten bzw. aufgespannten Fläche erfolgt. Als Justagehilfsmittel wird dabei vorteilhaft das vom Wandler z.B. von einer Laserdiode, einer LED oder IRED emittierte Licht verwendet. Die als Koppeloptik auf einem Träger befestigte Linse ist vorzugsweise eine Kugel- oder Zylinderlinse.

Von besonderem Vorteil insbesondere im Hinblick auf die Kompaktheit der Anordnung und auf einen noch geringeren Justage- und Befestigungsaufwand kann es sein, die Linse in Form eines Zylinders, einer Kugel, einer Halbkugel oder eines Kugelabschnittes in den Träger zu integrieren. Diese Maßnahme ist besonders dann von Vorteil, wenn Träger und Linse aus dem gleichen Material, beispielsweise Silizium bestehen und ein einheitliches Ganzes bilden. Es kann auch vorteilhaft sein, statt des aus einem Stück bestehenden Linsenträgers mit integrierter Linse einen Spiegel als Koppeloptik zu verwenden.

Anhand von in den Figuren der Zeichnung dargestellten Ausführungsbeispielen wird die Erfindung im folgenden näher erläutert. Es zeigen
- FIG 1: eine Vorderansicht eines optoelektronischen Wandlers in Form eines Lasermoduls,
- FIG 2: eine Seitenansicht des Lasermoduls nach FIG 1 mit einem Gehäuse und
- FIG 3: eine Seitenansicht eines weiteren optoelektronischen Wandlers in Form eines Detektors.

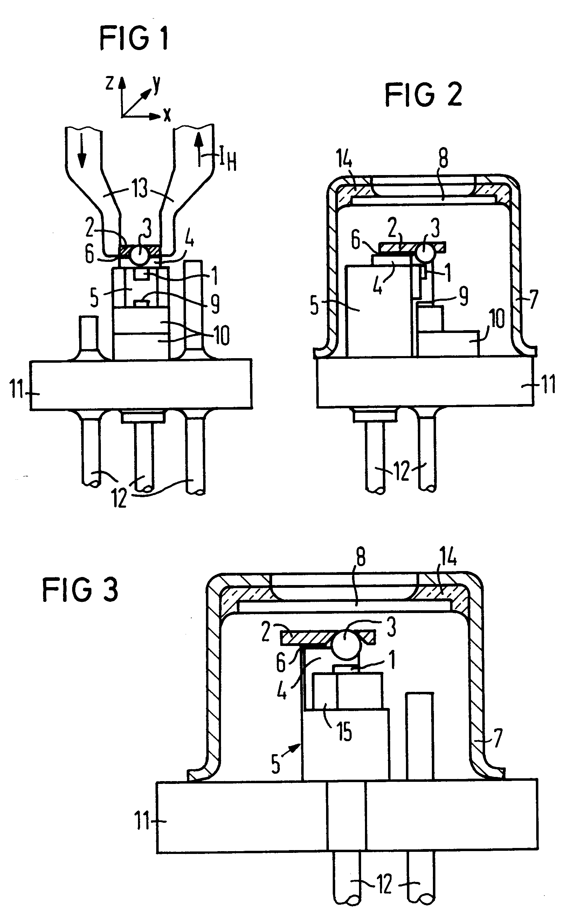

Der in den FIG 1 und 2 dargestellte optoelektronische Wandler besteht im wesentlichen aus der Laserdiode 1 mit einer Linsenkoppeloptik, bei der im Strahlengang unmittelbar vor der Laserdiode 1 eine Linse 3, in diesem Beispiel eine Kugellinse, auf einem Linsenträger 2, der beispielsweise aus Silizium besteht, angeordnet ist. Die Kugellinse 3 ist in einer vorzugsweise pyramidenstumpfförmigen Öffnung im Linsenträger 2 befestigt. Eine solche Öffnung läßt sich im Falle der Verwendung von Silizium als Material für den Linsenträger 2 vorteilhaft durch anisotropes Ätzen herstellen. Die Linsenbefestigung erfolgt in der Öffnung beispielsweise durch Löten oder Kleben. Der Linsenträger 2 mit der Linse 3 ist über eine Befestigungsschicht 6, vorzugsweise eine Weichlotschicht, zur Strahlachse des Wandlers (Laserdiode 1) justiert und anschließend an einem Befestigungsteil 4 fixiert, das als Wärmesperre dient und beispielsweise aus Glas besteht. Das Befestigungsteil 4 ist Teil eines gemeinsamen Trägers 5 für den optoelektronischen Wandler, d.h. in diesem Beispiel für die Laserdiode 1. In diesem Fall der Verwendung einer Laserdiode 1 als Wandlerbauelement ist es besonders zweckmäßig, den gemeinsamen Träger 5 als Wärmesenke für die Laserdiode 1 auszubilden. Die Laserdiode 1 als Wandlerelement und der Linsenträger 2 mit der darin befestigten Linse 3 sind auf dem gemeinsamen Träger 5 in einer solchen räumlichen Relation zueinander befestigt, daß die Strahlachse der Laserdiode 1 senkrecht auf der von der Befestigungsschicht 6 gebildeten Fläche steht.
Bedingt durch den in diesem Beispiel verwendeten modularen Aufbau der Laserdiode 1, die dabei als zentrale Einheit fungiert, ist zur Regelung auf konstante Strahlungsleistung insbesondere für Lichtwellenleiter-Übertragungszwecke noch eine Monitordiode 9 vorgesehen, die auf zwei, beispielsweise aus Keramik bestehenden Abstandsteilen 10 im rückseitigen Strahlengang der Laserdiode 1 befestigt ist. Die Abstandsteile 10 sind auf einem Sockelteil 11 angebracht, durch das auch die elektrischen Zuleitungen 12 für die aktiven Bauelemente, d.h. die Laserdiode 1 und die Monitordiode 9 hermetisch dicht hindurchgeführt sind.

In FIG 1 ist außerdem die zur Justage und Fixierung der Linse 3 bzw. des Linsenträgers 2 verwendete Heiz- und Justiereinrichtung rein schematisch dargestellt.

Die Heiz- und Justiervorrichtung besteht im wesentlichen aus zwei zangenförmig ausgebildeten Elektroden 13, durch die ein Heizstrom I_{H} geschickt werden kann und die an einem nicht dargestellten X, Y, Z-Manipulator befestigt sind. Zum Justieren des Linsenträgers 2 mit der Linse 3 wird dieser in die beiden Elektroden 13 eingeklemmt. Zum Aufschmelzen der vorzugsweise aus Weichlot bestehenden Befestigungsschicht 6 wird die Verlustleistung des Linsenträgers 2 bei Stromdurchfluß I_{H} zur Aufheizung ausgenutzt, und zwar durch den dabei gebildeten Metall-Halbleiter-(Schottky-)Kontakt und den Bahnwiderstand des verwendeten Materials. Die Linsenabstandsjustage erfolgt in z-Richtung, die identisch mit der Strahlachse des optoelektronischen Wandlers, d.h. in diesem Beispiel mit der Strahlachse der Laserdiode 1 ist. Die Feinjustage erfolgt in der Ebene der von der Befestigungsschicht 6 aufgespannten Fläche, d.h. in x- und y-Richtung.

In dem Fall, daß Linse 3 und Linsenträger 2 zwei Einzelteile bilden und somit zunächst die Linse 3 auf dem Linsenträger 2 und dann dieser auf dem Befestigungsteil 4 über die Befestigungsschicht 6 justiert und anschließend fixiert wird, ist es besonders zweckmäßig, für die Linsenbefestigung auf dem Träger 2 ein Lot, Glaslot oder einem Kleber mit einem höheren Schmelzpunkt zu verwenden als für die Befestigungsschicht 6. Damit wird erreicht, daß sich beim Justieren und Fixieren des Linsenträgers 2 auf dem Befestigungsteil 4 die Linse 3 nicht wieder aus ihrer Verankerung in der Öffnung des Linsenträgers 2 löst.

Bei dem in FIG 2 dargestellten Ausführungsbeispiel ist die im Zusammenhang mit FIG 1 beschriebene Anordnung von einem kappenförmigen Gehäuse 7 hermetisch dicht umschlossen und somit gegen störende Umgebungseinflüsse abgeschirmt. Das Gehäuse 7 besteht z.B. aus einer Fe-Co-Ni-Einschmelzlegierung und weist in seinem Oberteil als Lichtaustrittsöffnung in diesem Beispiel ein Planfenster 8 auf, das mittels einer Einglasung 14 am Gehäuse 7 befestigt ist. Die plane Fläche des Fensters 8 verläuft dabei senkrecht oder unter einem Winkel α zur Strahlachse der als Wandler verwendeten Laserdiode 1 und parallel oder unter einem Winkel β zu der zwischen Linsenträger 2 und Befestigungsteil 4 befindlichen Befestigungsschicht 6.

Der in FIG. 3 dargestellte optoelektronische Wandler mit einer Linsenkoppeloptik ist als Strahlungsdetektor 1 ausgebildet und von einem kappenförmigen Gehäuse 7 umgeben, das an einem mit den elektrischen Zuführungen 12 versehenen Sokkelteil 11 hermetisch dicht befestigt ist. In das kappenförmige Gehäuse 7 ist in seinem Oberteil ein Planfenster 8 als Lichteintrittsöffnung mittels einer Einglasung 14 eingeglast. Die plane Fläche des Fensters 8 steht senkrecht auf der Strahlachse des Detektors 1 und verläuft parallel zu der Befestigungsschicht 6, die zur Justage und Fixierung des mit der Linse 3 versehenen Linsenträgers 2 dient. Das als optoelektronischer Wandler verwendete Detektorbauelement ist in diesem Ausführungsbeispiel eine Fotodiode 1. Die Fotodiode 1 ist auf dem gemeinsamen Träger 5 in einer solchen räumlichen Relation zu dem mit einer Kugellinse 3 versehenen Linsenträger 2 befestigt, daß die Strahlachse der Fotodiode 1 senkrecht auf der von der Befestigungsschicht 6, vorzugsweise Weichlotschicht, gebildeten Fläche steht. Die Befestigungsschicht 6 bzw. das Justagelot befindet sich zwischen dem Linsenträger 2 und dem Befestigungsteil 4, das in diesem Beispiel ein Bestandteil des gemeinsamen Trägers 5 ist. Der gemeinsame Träger 5 mit Befestigungsteil 4 ist beispielsweise ein Metall- oder Keramikteil. Der gemeinsame Träger 5 ist an dem Sockelteil 11 befestigt. Der gemeinsame Träger 5 fungiert dabei auch als Abstandsteil bzw. Höhenabstandshalter und Montageblock. Die Fotodiode 1 ist auf einem Isolierkörper 15, beispielsweise einem Al₂O₃-Isolator befestigt und damit gegen den gemeinsamen Träger 5 isoliert, insbesondere wenn dieser aus Metall besteht. Die Justage und Fixierung des Linsenhalters 2 mit der Linse 3 auf dem Befestigungsteil 4 des gemeinsamen Trägers 5 mittels der Befestigungsschicht 6 wird vorzugsweise mit dem im Zusammenhang mit FIG 1 geschilderten Verfahren und der dazu verwendeten Vorrichtung durchgeführt.

## Patentansprüche

1. Optoelektronisches Modul mit einem optoelektronischen Wandler und einer Linsenanordnung, bei der im Strahlengang unmittelbar vor dem Wandler eine Linse mit einem Linsenträger angeordnet ist, der mit der Linse zur Strahlachse des Wandlers justiert durch eine Befestigungsschicht auf einem Befestigungsteil fixiert ist, das Teil eines gemeinsamen Trägers für den Wandler ist, **dadurch gekennzeichnet**, daß der Linsenträger (2) aus einem Silizium plättchen besteht, in das die Linse integriert ist und daß der optoelektronische Wandler (1), das Befestigungsteil (4) und der Linsenträger (2) mit der Linse (3) auf dem gemeinsamen Träger (5) befestigt sind, wobei der Linsenträger (2) an einer Fläche des Befestigungsteils (4) angelötet ist, die senkrecht zur Strahlachse steht, so daß die Strahlachse des Wandlers (1) senkrecht auf der von dem Befestigungsteil (4) gebildeten Fläche steht.

2. Modul nach Anspruch 1, **dadurch gekennzeichnet**, daß die Linse (3) eine Kugel- oder Zylinderlinse oder eine plankonvexe Linse ist.

3. Modul nach Anspruch 1 oder 2, **dadurch gekennzeichnet**, daß die Linse (3) und der Linsenträger (2) ein einheitliches Lanzes bilden.

4. Modul nach Anspruch 1 oder 2, **dadurch gekennzeichnet**, daß die Linse (3) eine Kugeloder Zylinderlinse ist und in einer Öffnung im Linsenträger (2) befestigt ist.

5. Modul nach einem der Ansprüche 1 bis 4, **dadurch gekennzeichnet**, daß die Befestigungsschicht (6) eine Schicht mit variierbarer Dicke ist.

6. Modul nach einem der Ansprüche 1 bis 5, **dadurch gekennzeichnet**, daß der Wandler (1) von einem kappenförmigen Gehäuse (7) hermetisch dicht umschlossen ist, das in seinem Oberteil ein Planfenster (8) aufweist, dessen plane Fläche senkrecht oder unter einem Winkel α zur Strahlachse des Wandlers (1) und parallel oder unter einem Winkel β zu der zwischen Linsenträger (2) und Befestigungsteil (4) befindlichen Befestigungsschicht (6) verläuft.

7. Modul nach einem der Ansprüche 1 bis 6, **dadurch gekennzeichnet**, daß der Wandler (1) eine Laserdiode ist und der gemeinsame Träger (5) als Wärmesenke dient.

8. Modul nach einem der Ansprüche 1 bis 6, **dadurch gekennzeichnet**, daß der Wandler (1) eine LED oder eine IRED ist.

9. Modul nach einem der Ansprüche 1 bis 6, **dadurch gekennzeichnet**, daß der Wandler (1) eine Fotodiode ist.

10. Verwendung eines Moduls nach einem der Ansprüche 1 bis 9 als Lichtquelle.

11. Verwendung eines Moduls nach einem der Ansprüche 1 bis 9 als Lichtwellenleiter-Sendemodul oder als Lichtwellenleiter-Empfangsmodul.

## Claims

1. Optoelectronic module having an optoelectronic converter and a lens arrangement, in which there is arranged in the beam path directly in front of the converter a lens with a lens carrier which is fixed by means of a securing layer, with the lens adjusted to the beam axis of the converter, to a securing part which is a part of a common carrier for the converter, characterized in that the lens carrier (2) comprises a silicon wafer in which the lens is integrated, and in that the optoelectronic converter (1), the securing part (4) and the lens carrier (2) with the lens (3) are secured on the common carrier (5), the lens carrier (2) being soldered onto a surface of the securing part (4) which is perpendicular to the beam axis, in such a way that the beam axis of the converter (1) is perpendicular to the surface formed by the securing part (4).

2. Module according to Claim 1, characterized in that the lens (3) is a spherical or cylindrical lens or a plano-convex lens.

3. Module according to Claim 1 or 2, characterized in that the lens (3) and the lens carrier (2) form a unitary whole.

4. Module according to Claim 1 or 2, characterized in that the lens (3) is a spherical or cylindrical lens and is secured in an opening in the lens carrier (2).

5. Module according to one of Claims 1 to 4, characterized in that the securing layer (6) is a layer whose thickness may be varied.

6. Module according to one of Claims 1 to 5, characterized in that the converter (1) is hermetically tightly enclosed by a cap-shaped housing (7), which has a planar window (8) in its upper part, the planar surface of the said planar window (8) extending perpendicular or at an angle α to the beam axis of the converter (1) and parallel or at an angle β to the securing layer (6) located between lens carrier (2) and securing part (4).

7. Module according to one of Claims 1 to 6, characterized in that the converter (1) is a laser diode and the common carrier (5) serves as a heat sink.

8. Module according to one of Claims 1 to 6, characterized in that the converter (1) is an LED (light-emitting diode) or an IRED (infrared-emitting diode).

9. Module according to one of Claims 1 to 6, characterized in that the converter (1) is a photodiode.

10. Use of a module according to one of Claims 1 to 9 as a light source.

11. Use of a module according to one of Claims 1 to 9 as an optical waveguide transmitting module or as an optical waveguide receiving module.

## Revendications

1. Module optoélectronique comportant un transducteur optoélectronique et un dispositif à lentilles, et dans lequel, dans le trajet du rayonnement, est disposée, directement en avant du transducteur, une lentille à porte-lentille qui est fixé à la lentille, d'une manière ajustée par rapport à l'axe du faisceau du transducteur, au moyen d'une couche de fixation sur une partie de fixation, qui fait partie d'un support commun pour le transducteur, caractérisé par le fait que le porte-lentille (2) est constitué par une plaquette de silicium, dans laquelle est intégrée la lentille, et que le transducteur optoélectronique (1), la partie de fixation (4) et le porte-lentille (2) sont fixés à la lentille (3) sur le support commun (5), le porte-lentille (2) étant fixé par brasage à une surface de la partie de fixation (4), qui est perpendiculaire à l'axe du faisceau, de sorte que l'axe du faisceau du transducteur (1) est perpendiculaire à la surface formée par la partie de fixation (4).

2. Module suivant la revendication 1, caractérisé par le fait que la lentille (3) est une lentille de forme sphérique ou cylindrique ou une lentille plan-convexe.

3. Module suivant la revendication 1 ou 2, caractérisé par le fait que la lentille (3) et le porte-lentille (2) forment un ensemble unitaire.

4. Module suivant la revendication 1 ou 2, caractérisé par le fait que la lentille (3) est une lentille sphérique ou une lentille cylindrique et est fixée dans une ouverture ménagée dans le porte-lentille (2).

5. Module suivant l'une des revendications 2 à 4, caractérisé par le fait que la couche de fixation (6) est une couche d'épaisseur variable.

6. Module suivant l'une des revendications 1 à 5, caractérisé par le fait que le transducteur (1) est entouré, d'une manière étanche, par un boîtier en forme de capuchon (7), qui possède, dans sa partie supérieure, une fenêtre plane (8), dont la surface plane est perpendiculaire à l'axe du faisceau du transducteur (1) ou fait un angle α par rapport à cet axe et est parallèle à la couche de fixation (6) située entre le porte-lentille (2) et la partie de fixation (4), ou fait un angle a par rapport à cette couche de fixation.

7. Module suivant l'une des revendications 1 à 6, caractérisé par le fait que le transducteur (1) est une diode laser et que le support commun (5) est utilisé en tant que puits de chaleur.

8. Module suivant l'une des revendications 1 à 6, caractérisé par le fait que le transducteur (1) est une diode LED ou une diode IRED.

9. Module suivant l'une des revendications 1 à 6, caractérisé par le fait que le transducteur (1) est une photodiode.

10. Utilisation d'un module suivant l'une des revendications 1 à 9 en tant que source de lumière.

11. Utilisation d'un module suivant l'une des revendications 1 à 9 en tant que module d'émission à guide d'ondes lumineuses ou en tant que module de réception à guide d'ondes lumineuses.
